**Europäisches Patentamt**

**European Patent Office**

**Office européen des brevets**

(11) Veröffentlichungsnummer: **0 416 240 A2**

# EUROPÄISCHE PATENTANMELDUNG

(21) Anmeldenummer: **90113039.3**

(22) Anmeldetag: **07.07.90**

(51) Int. Cl.5: **H01L 21/76**

Die Bezeichnung der Erfindung wurde geändert (Richtlinien für die Prüfung im EPA, A-III, 7.3).

(30) Priorität: **21.07.89 DE 3924062**

(43) Veröffentlichungstag der Anmeldung:
**13.03.91 Patentblatt 91/11**

(84) Benannte Vertragsstaaten:
**DE FR GB IT NL**

(71) Anmelder: **EUROSIL electronic GmbH**
**Erfurter Strasse 16**
**W-8057 Eching(DE)**

(72) Erfinder: **Fischer, Gerhard, Dr.**
**Siedlerstrasse 17a**
**W-8044 Unterschleissheim(DE)**
Erfinder: **Lehner, Ute**
**Hauptstrasse 17**
**W-8044 Unterschleissheim(DE)**
Erfinder: **Otto, Joachim**
**St. Benedikt Strasse 17**
**W-8044 Unterschleissheim(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) **Halbleiterbauelement mit einer Isolierzone aus Oxid.**

(57) Die Erfindung betrifft ein Halbleiterbauelement, insbesondere ein CMOS-Bauelement, mit einer aus Oxid bestehenden Oberflächenschicht, die zur Trennung der aktiven und/oder passiven Elemente des Halbleiterbauelementes auf ersten Bereichen der Oberfläche eines Halbleiterkörpers angeordnet ist, mit dieser Oberflächenoxidschicht benachbarten, in dem Halbleiterkörper angeordneten zweiten Bereichen, deren Dotierungen entgegengesetzt zu der des Halbleiterkörpers sind und die die Komponenten der aktiven und passiven Elemente bilden, und mit einer in dem Halbleiterkörper angeordneten, direkt unter der Oberflächenoxidschicht sich anschließen-den Isolierzone, deren Dotierungsniveau höher als das Dotierungsniveau des Halbleiterkörpers ist. Solche Isolierzonen setzen die Feldschwellspannungen von parasitären p- und n-Kanaltransistoren herauf, wobei jedoch in nachteiliger Weise die Diodendurchbruchspannungen zwischen diesen Isolierzonen und den zweiten Bereichen, also den Source- bzw. Drain-Bereichen, wesentlich herabgesetzt werden. Zur Vermeidung dieses Nachteils weisen die Ränder dieser Isolierzonen erfindungsgemäß wenigstens zu einem der zweiten Bereiche einen Abstand auf.

EP 0 416 240 A2

FIG.8

## HALBLEITERBAUELEMENT

Die Erfindung betrifft ein Halbleiterbauelement, insbesondere CMOS-Bauelemente gemäß dem Oberbegriff des Anspruches 1 sowie ein Verfahren zu dessen Herstellung.

Genauer gesagt, betrifft die Erfindung die Herstellung von Hochvoltschaltungsteilen, wie elektrisch löschbare Speicherelemente (EEPROM) mit zugehörigen Ansteuertransistoren, die hohe Programmier- und Löschspannungen von beispielsweise 18 V erfordern, und Niedervolt-Logikelemente mit einer Schaltspannung von beispielsweise 1,5 V auf einem einzigen Chip.

Die Fertigung von Hochvoltschaltungsteilen erfordert in der Regel zusätzlichen Prozeßaufwand, indem die Transistoren in den Hochvoltschaltungsteilen mit dickerem Gateoxid hergestellt werden, was jedoch eine zweite Gateoxidation nötig macht. Zudem sind die Dotierungen von Kanalgebieten und Feld gebieten in Hochvolt- und Niedervoltschaltungsteilen unterschiedlich einzustellen. Dieses Verfahren erfordert deshalb eine Reihe zusätzlicher Implantationsschritte und die Erzeugung der zugehörigen Maskierungsschichten.

Da zur Programmierung einer EEPROM-Zelle hohe Spannungen benötigt werden, ist eine hohe Schwellwertspannung der parasitären Transistoren notwendig, die bei einer Programmierspannung von 18 V über 20 V betragen sollte.

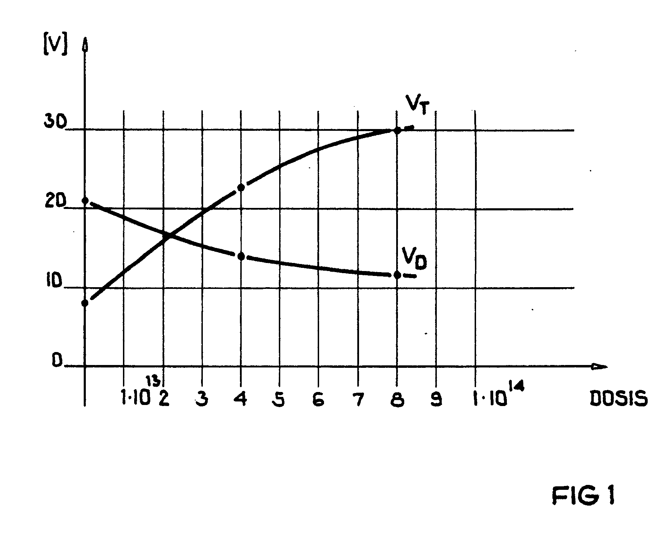

Eine hohe Schwellwertspannung erreicht man dadurch, daß man die Dotierung von Silizium in dem Bereich direkt unterhalb des Feldoxids wesentlich erhöht. Eine solche vergrößerte Dotierung verschlechtert jedoch entscheidend die Kennwerte der Lawinendurchbruchspannung des Überganges entlang der Kante dieser Isolierzone zu den angrenzenden Elektrodenbereichen, wie beispielsweise der Drain- oder Source-Zone eines Transistors. Es ergibt sich also bei einem n-Kanal-Transistor die Problematik, daß durch die Erhöhung der Feldschwellspannung durch die Feldimplantation gleichzeitig die Diodendurchbruchspannung der $n^+p^-$-Dioden erniedrigt wird. Diese Abhängigkeit zeigt die Figur 1, wonach in Abhängigkeit der Dotierung der sich unterhalb des Feldoxids angeordneten Isolierzone die Schwellwertspannung $V_T$ bzw. die Diodendurchbruchspannung $V_D$ aufgetragen ist. Aus dem Verlauf dieser beiden Kurven wird ersichtlich, daß nicht gleichzeitig eine über 20 V liegende Schwellwertspannung eines parasitären Transistors und gleichzeitig eine über 20 V liegende Diodendurchbruchspannung erzielbar sind.

Es ist deshalb eine Aufgabe der vorliegenden Erfindung, ein Halbleiterbauelement der eingangs genannten Art anzugeben, das eine hohe Schwellwertspannung der parasitären Transistoren und gleichzeitig eine hohe Diodendurchbruchspannung aufweist. Es ist eine weitere Aufgabe der vorliegenden Erfindung, ein einfaches Verfahren für die Herstellung solcher Bauelemente anzugeben.

Die Lösung dieser Aufgaben erfolgt gemäß den kennzeichnenden Merkmalen des Anspruches 1 sowie des Anspruches 4.

Diese an sich widersprechenden Bedingungen einer hohen Feldschwellspannung und gleichzeitig einer hohen Diodendurchbruchspannung werden erfindungsgemäß also dadurch gelöst, daß die direkt unter der Feldoxidschicht angeordnete Isolierschicht - auch Feldimplantat genannt -durch dessen Zurücksetzen um einen gewissen Abstand von allen Aktiv-Gebieten im Hochvoltschaltungsteil erfolgt.

Gemäß einer besonders bevorzugten Ausführungsform der Erfindung eines Halbleiterbauelementes mit einer in einer Wanne eines zweiten Leitungstyps eines Halbleiterkörpers vom ersten Leitungstyp angeordneten elektrisch löschbaren Speicherzelle und Niedervolt-Logikelementen ist die unter der auf einem ersten Bereich der Oberfläche der Wanne angeordneten und zur Trennung der elektrisch löschbaren Speicherzelle und den Niedervolt-Logikelementen vorgesehene Oberflächenoxidschicht angeordnete Isolierzone zu dem dieser Oberflächenoxidschicht benachbarten, eine Elektrode der Speicherzelle darstellenden Bereich einen Abstand aufweist.

Gemäß einer vorteilhaften Weiterbildung dieses Ausführungsbeispieles der Erfindung beträgt dieser Abstand 2 μm.

Die Herstellung eines solchen erfindungsgemäßen Bauelementes, das eine EEPROM-Zelle sowie Niedervolt-Logikelemente hält, zeichnet sich durch äußerste Einfachheit aus. Weitere vorteilhafte Weiterbildungen dieses Verfahrens sind aus den Unteransprüchen 5 bis 13 entnehmbar.

Im folgenden soll die Erfindung anhand eines Ausführungsbeispieles in Verbindung mit der Zeichnung erläutert werden. Es zeigen:

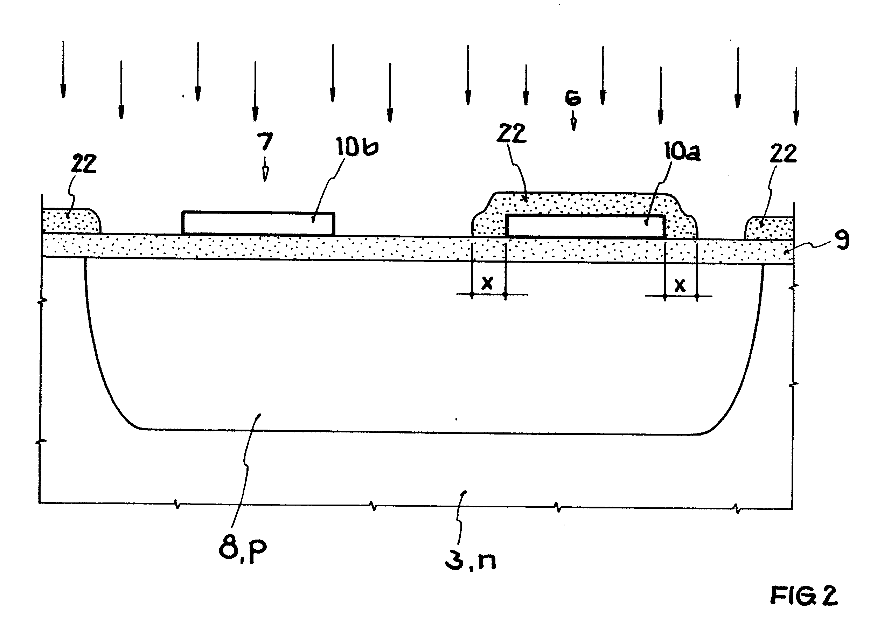

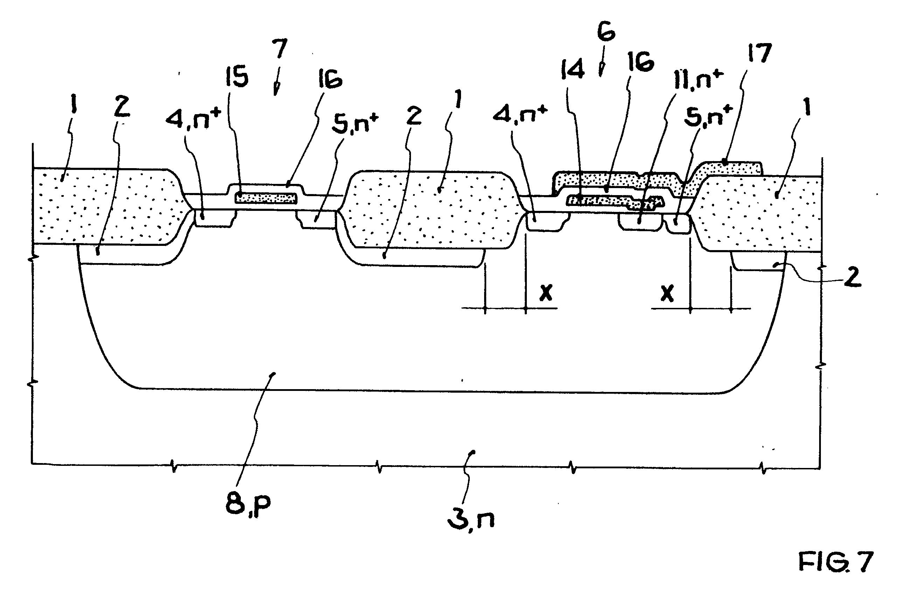

Figur 2 bis Figur 8 jeweils eine schematische Darstellung der Herstellungsschritte eines Ausführungsbeispieles des erfindungsgemäßen Halbleiterbauelementes.

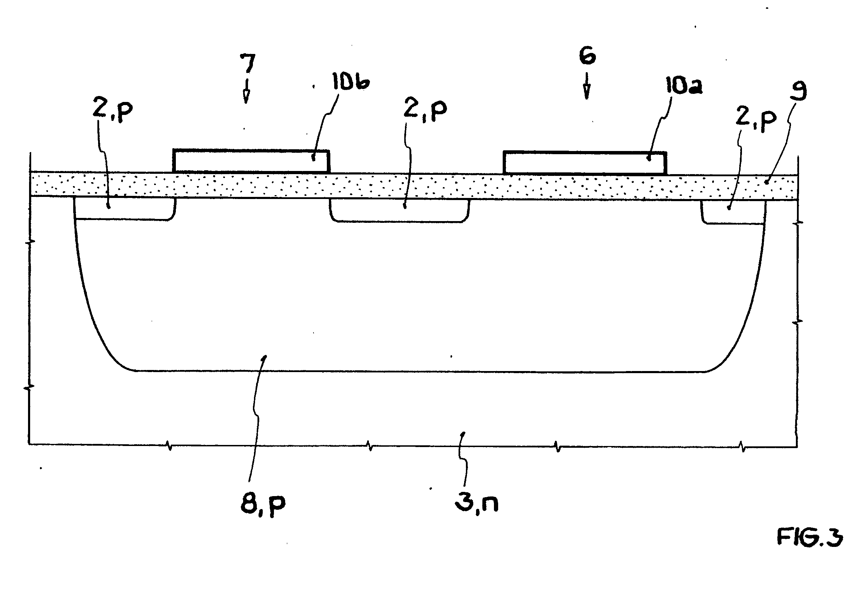

Die Figur 2 zeigt ein einkristallines Halbleitersubstrat 3 aus n-dotiertem Silizium mit einer p-Wanne 8, in die eine, mit dem Bezugszeichen 6 angedeutete EEPROM-Speicherzelle und ein, mit dem Bezugszeichen 7 angedeuteter Niedervolt-Logiktransistor zu integrieren sind. Bei der in Figur 2 gezeigten Herstellungsstufe ist ferner eine Siliziumdioxidschicht 9 sowie eine schon strukturierte Silizium-Nitridschicht 10 auf der Oberfläche des Halbleitersubstrats 3 vorhanden. Die von der Silizium-Nitrid schicht 10a und 10b abgedeckten Bereiche sind für die aktiven Gebiete der Speicherzelle und des Transistors vorgesehen. Schließlich zeigt die Figur 2 eine strukturierte Photolackschicht 22 zur Erzeugung der Isolierzonen 2 gemäß der Figur 3. Hierbei ist besonders auf die Silizium-Nitridschicht 10a hinzuweisen, wo die Photolackschicht 22 an deren Rändern um einen gewissen Abstand x übersteht, wobei der Wert dieses Abstandes x ca. 2 $\mu$m beträgt. Durch die Pfeile in der Figur 2 ist angedeutet, daß diese Isolierzonen 2 mittels Ionenimplantation, beispielsweise mit 8 x $10^{13}$ Atome/cm$^2$ erzeugt werden. Anschließend wird die Photolackschicht 22 entfernt; es ergibt sich ein Zustand gemäß Figur 3 mit den p-dotierten Isolierzonen 2, die im folgenden Feldimplantate genannt werden.

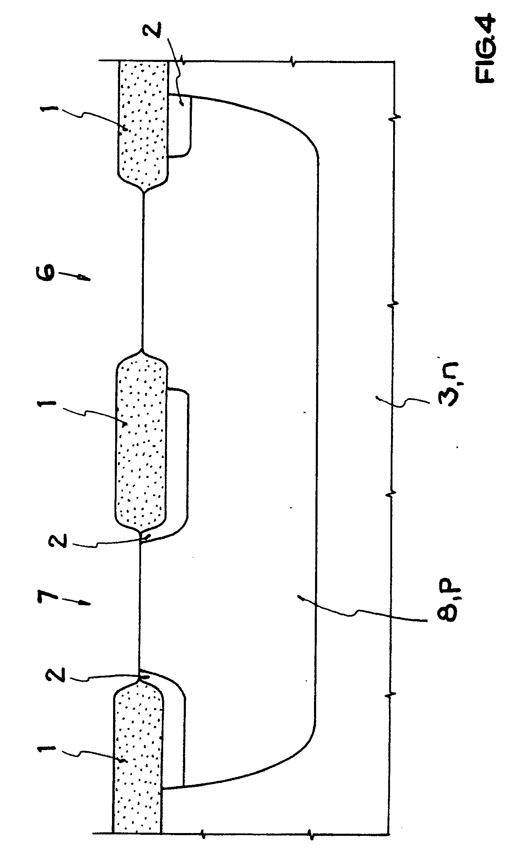

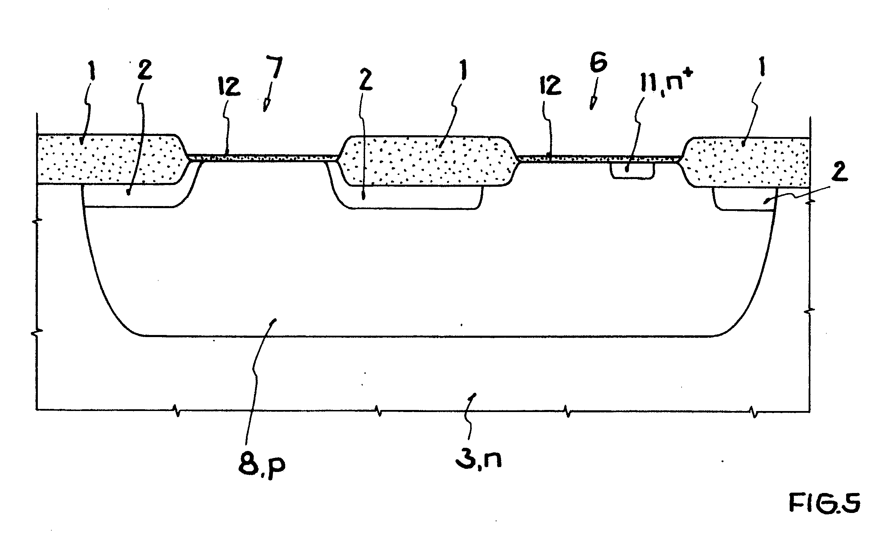

Im nächsten Verfahrensschritt erfolgt außerhalb der Bereiche der Silizium-Nitridschicht 10a und 10b die Erzeugung einer Oberflächenoxidschicht 1 - die auch Feldoxidschicht genannt wird - mittels lokaler Oxidation, wobei die Silizium-Nitridschicht 10a und 10b als Maske dient. Diesen Zustand stellt die Figur 4 dar, wonach ein dickes Feldoxid 1 mit einer Dicke von ca. 0,8 $\mu$m erzeugt und die aktiven Bereiche durch Entfernung der Oxidschicht 9 und der Silizium-Nitridschicht 10a und 10b freigelegt wurden. Nun sind deutlich in dem mit dem Bezugszeichen 6 versehenen Bereich die zurückgesetzten Feldimplantate 2 in dieser Figur 4 zu erkennen. Das Bezugszeichen 7 kennzeichnet dagegen einen Bereich, wo die Feldimplantate 2 bis an die Oberfläche der p-Wanne 8 verlaufen. Im anschließenden Verfahrensschritt wird gemäß Figur 5 an den freigelegten Bereichen 6 und 7 der p-Wanne 8 eine Gate-Oxidschicht 12 mit einer Dicke von ca. 0,05 $\mu$m aufgebracht sowie das n$^+$-dotierte Tunnelübergangsgebiet 11 der Speicherzelle erzeugt.

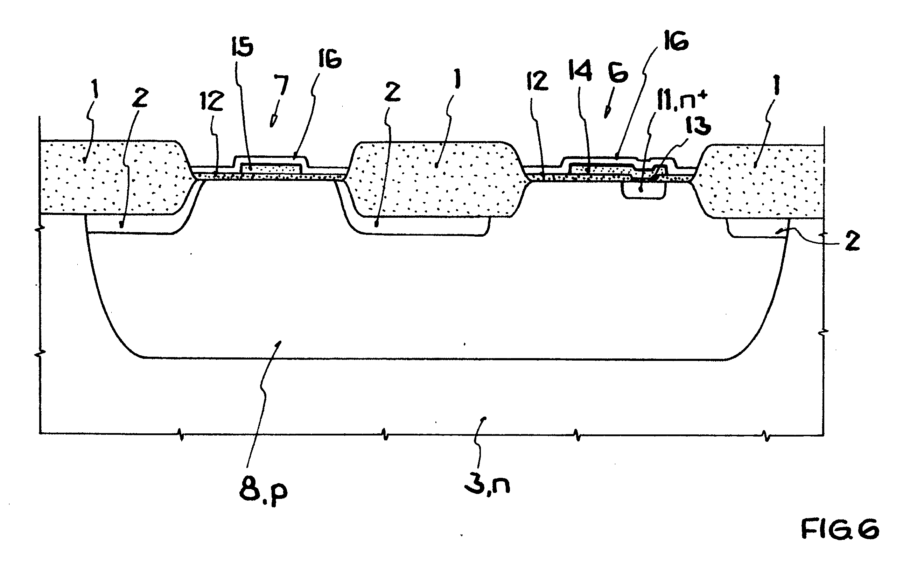

Die Figur 6 zeigt das CMOS-Bauelement nach weiteren Verfahrensschritten, wonach das Tunneloxid 13 im Bereich des Tunnelübergangsgebietes 11 hergestellt wurde und anschließend im Bereich 6 die Floating-Gate-Elektrode 14 als auch im Bereich 7 die Gate-Elektrode 15 aus Polysilizium erzeugt wurden. Beide Elektroden 14 und 15 werden abschließend mit einer Zwischenisolationsschicht 16 aus Polysiliziumdioxid abgedeckt.

In einem nächsten Verfahrensschritt werden die n$^+$-dotierten Source- und Drain-Zonen 4 und 5 im Bereich 6 der herzustellenden EEPROM-Speicherzelle sowie im Bereich 7 des herzustellenden n-Kanal-Transistors implantiert. Dadurch, daß die Herstellung der Zwischenisolationsschicht 16 vor die Source-Drain-Implantation gelegt ist, wird eine Unterdiffusion vermieden, d. h., ansonsten würde aufgrund der Wärmebehandlung zur Herstellung der Zwischenisolationsschicht 16 die Source- und Drain-Zonen sich verbreitern, mit der Folge einer Verminderung der Dotierungskonzentration. Auf die Zwischenisolationsschicht 16 wird schließlich eine zweite Polysiliziumschicht, die Control-Gate-Elektrode 17, im Bereich 6 aufgebracht und strukturiert.

Die letzten Herstellungsschritte beinhalten das Abscheiden einer letzten Isolationsschicht 18 auf der gesamten Oberfläche. Diese Isolationsschicht 18 besteht aus Phosphorglas, wodurch im Bereich 6 die darunterliegende Polysiliziumschicht 17 dotiert wird. Dadurch entfällt eine weitere Implantation und damit können mehrere zusätzliche Herstellungsschritte im Prozeßablauf eingespart werden.

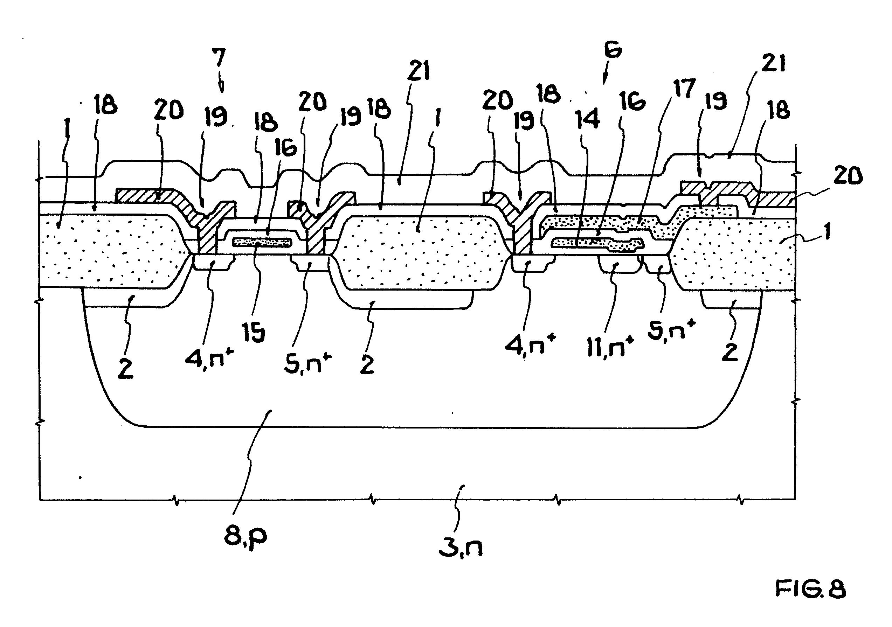

Des weiteren erfolgt die Herstellung der Kontaktlöcher 19 in der letzten Isolationsschicht 18 sowie die Abscheidung und Strukturierung einer Metalleitbahnebene 20. Zum Schluß wird die Oberfläche mit einer Passivierungsschicht 21 abgedeckt. Dieses fertiggestellte Bauelement zeigt die Figur 8, wonach im Bereich 6 die EEPROM-Speicherzelle und im Bereich 7 ein n-Kanal-Transistor erzeugt ist. Dadurch, daß die Feldimplantate 2 von dem Source- bzw. Drain-Bereich 4 bzw. 5 der EEPROM-Speicherzelle 6 beabstandet sind, ergibt sich für die pn$^+$-Dioden eine ausreichend hohe Durchbruchspannung.

Die Erfindung ist natürlich nicht nur auf CMOS-Bauelemente beschränkt, sondern ist allgemein bei unipolaren Halbleiterbauelementen, ob sie linear integrierte Schaltkreise oder digital integrierte Schaltkreise von kleinem, mittlerem, großem oder sehr großem Integrationsgrad sind, anwendbar.

**Ansprüche**

1) Halbleiterbauelement, insbesondere CMOS-Bauelement, mit einer aus Oxid bestehenden Oberflächenschicht (1), die zur Trennung der aktiven und/oder passiven Elemente (6, 7) des Halbleiterbauelementes auf ersten Bereichen der Oberfläche eines Halbleiterkörpers (3) angeordnet ist, mit dieser Oberflächenoxidschicht (1) benachbarten, in dem Halbleiterkörper (3) angeordneten zweiten Bereichen (4, 5), deren Dotierungen entgegengesetzt zu derjenigen des diese zweiten Bereiche (4, 5) aufnehmenden Bereiches des Halbleiterkörpers (3) ist und die die Komponenten der aktiven und passiven Elemente (6, 7) bilden, und mit einer in dem Halbleiterkörper (3) angeordneten, direkt unterhalb der Oberflächenoxidschicht (1) sich anschließenden Isolierzone (2), deren Dotierungsniveau höher als das Dotierungsniveau des diese Isolationszone (2) aufnehmenden Bereiches des Halbleiterkörpers (3) ist, dadurch gekennzeichnet, daß der Rand der Isolierzone (2) wenigstens zu einem der zweiten Bereiche (4, 5) einen Abstand (x) aufweist.

2) Halbleiterbauelement nach Anspruch 1, mit einer in einer Wanne (8) eines zweiten Leitungstyps eines Halbleiterkörpers (3) eines ersten Leitungstyps angeordneten, elektrisch löschbaren Speicherzelle (6) und Niedervolt-Logikelementen (7), dadurch gekennzeichnet, daß der Rand der unter der auf einem ersten Bereich der Oberfläche der Wanne (8) angeordneten und zur Trennung der elektrisch löschbaren Speicherzelle (6) und den Niedervolt-Logikelementen (7) vorgesehene Oberflächenoxidschicht (1) angeordnete Isolierzone (2) zu dem dieser Oberflächenoxidschicht (1) benachbarten, eine Elektrode der elektrisch löschbaren Speicherzelle (6) darstellenden Bereich (4, 5) einen Abstand x aufweist.

3) Halbleiterbauelement nach Anspruch 1 oder 2, dadurch gekennzeichnet, daß der Abstand x ca. 2 μm beträgt.

4) Verfahren zum Herstellen eines Halbleiterbauelementes gemäß Anspruch 2 oder 3 mit folgenden Schritten:

a) Auf einem einkristallinen Halbleitersubstrat (3) eines ersten Leitungstyps werden nach erfolgter Herstellung einer Wanne (8) eines zweiten Leitungstyps eine erste und zweite Isolationsschicht (9, 10) aufgebracht,

b) Maskierung und Entfernung der zweiten Isolationsschicht (10) an den Stellen, die zwischen den herzustellenden Elementen, nämlich der Speicherzelle (6) und den Niedervolt-Logikelementen (7) liegen,

gekennzeichnet durch folgende Schritte:

c) Herstellung einer Maske, die am Rand der den aktiven Bereich der Speicherzelle (6) bildenden zweiten Isolationsschicht (10a) übersteht,

d) Herstellung der Isolierzonen (2) vom zweiten Leitungstyp,

e) Herstellung der Oberflächenoxidschicht (1) zur Trennung der Speicherzelle (6) von den Niedervolt-Logikelementen (7),

f) Entfernung der ersten und zweiten Isolationsschicht (9, 10) im Bereich der aktiven Gebiete der Speicherzelle (6) und der Niedervolt-Logikelemente (7),

g) Erzeugung einer Gate-Oxidschicht (12),

h) Maskierung der Oberfläche und Erzeugung eines Tunnelübergangsgebietes (11) im Bereich der den aktiven Bereich der Speicherzelle (6) bildenden zweiten Isolationsschicht (10a) vom ersten Leitungstyp,

i) Herstellung des Tunneloxids (13),

j) Erzeugung der Floating-Gate- bzw. der Gate-Elektroden (14 bzw. 15) und einer diese Elektroden bedeckenden Zwischenisolationsschicht (16),

k) Erzeugung der Source- und Drain-Zonen (4, 5),

l) Herstellung der Control-Gate-Elektrode (17) der Speicherzelle (6) und einer die gesamte Oberfläche bedeckende letzte Isolationsschicht (18),

m) Erzeugung der Kontaktlochbereiche (19) in der letzten Isolationsschicht (18) und der Metalleitbahnebene (20) in bekannter Weise,

n) Herstellung einer Passivierungsschicht (21).

5) Verfahren nach Anspruch 4, dadurch gekennzeichnet, daß die erste Isolationsschicht (9) aus Siliziumdioxid besteht.

6) Verfahren nach Anspruch 4 oder 5, dadurch gekennzeichnet, daß die zweite Isolationsschicht (10) aus Silizium-Nitrid besteht.

7) Verfahren nach einem der Ansprüche 4 bis 6, dadurch gekennzeichnet, daß im Verfahrensschritt f die Oberflächenoxidschicht (1) durch lokale Oxidation hergestellt wird.

8) Verfahren nach einem der Ansprüche 4 bis 7, dadurch gekennzeichnet, daß das Halbleitersubstrat (3) aus Silizium und die Oberflächenoxidschicht (1) aus Siliziumdioxid besteht.

9) Verfahren nach einem der Ansprüche 4 bis 8, dadurch gekennzeichnet, daß im Verfahrensschritt e die Isolierzonen (2) mittels Ionenimplantation und eines Photolackprozesses hergestellt werden.

10) Verfahren nach einem der Ansprüche 4 bis 9, dadurch gekennzeichnet, daß im Verfahrensschritt j und l die Gate-Elektroden (14, 15, 17) aus Polysilizium bestehen.

11) Verfahren nach einem der Ansprüche 4 bis 10, dadurch gekennzeichnet, daß zur Dotierung der Control-Gate-Elektrode (17) die letzte Isolationsschicht (18) im Verfahrensschritt e aus Phosphorglas besteht.

12) Verfahren nach einem der Ansprüche 4 bis 11, dadurch gekennzeichnet, daß im Verfahrensschritt j die Zwischenisolationsschicht (16) aus Polysiliziumdioxid besteht.

13) Verfahren nach einem der Ansprüche 4 bis 12, dadurch gekennzeichnet, daß die Source- und Drain-Zonen (4, 5) mittels Ionenimplantation erzeugt werden.

FIG 1

FIG 2

FIG.3

2,P  9

2,P  10a  6

7  10b  2,P

2,P

8,P

3,n

FIG.4

FIG.5

EP 0 416 240 A2

FIG 6

EP 0 416 240 A2

FIG. 7

EP 0 416 240 A2

FIG.8